# EUROPÄISCHE PATENTSCHRIFT

(11) **EP 3 881 418 B1**
(45) Veröffentlichungstag und Bekanntmachung des Hinweises auf die Patenterteilung: **19.10.2022**
(21) Anmeldenummer: 19829101.5
(22) Anmeldetag: 17.12.2019
(51) Int. Cl.: H02M 1/32, G01R 31/26, H01L 21/66, H03K 17/08

(54) **BESTIMMEN EINER NOCH VERBLEIBENDEN BESTIMMUNGSGEMÄSSEN NUTZBARKEIT EINES HALBLEITERMODULS**
DETERMINING A REMAINING INTENDED SERVICE LIFE OF A SEMICONDUCTOR MODULE
DÉTERMINATION DE LA DURÉE DE SERVICE PRÉVUE RESTANTE D'UN MODULE À SEMI-CONDUCTEUR

(30) Priorität: 30.01.2019 EP 19154453
(43) Veröffentlichungstag der Anmeldung: 22.09.2021
(73) Patentinhaber: Siemens Aktiengesellschaft, 80333 München (DE)
(72) Erfinder: DIETZ, Gunnar, 90478 Nürnberg (DE); MAUERSBERGER, Markus, 90763 Fürth (DE)
(86) Internationale Anmeldenummer: PCT/EP2019/085666
(87) Internationale Veröffentlichungsnummer: WO 2020/156733

(56) Entgegenhaltungen:
- EP-A1- 3 054 306
- EP-A1- 3 203 250
- JP-A- 2011 196 703
- JP-A- 2015 056 415
- JP-A- 2016 184 506
- US-A1- 2009 046 405
- US-A1- 2011 015 881

## Beschreibung

Erfindungsgemäß werden ein Verfahren nach Anspruch 1, ein weiteres Verfahren nach Anspruch 3, eine Steuereinheit nach Anspruch 10 und ein Energiewandler nach Anspruch 11 vorgeschlagen.

Verfahren, Steuereinheiten sowie Energiewandler der gattungsgemäßen Art sind dem Grunde nach im Stand der Technik umfänglich bekannt, so dass es eines gesonderten druckschriftlichen Nachweises hierfür nicht bedarf. Sie beziehen sich insbesondere auf die Nutzung von Halbleitermodulen, die im Stand der Technik vielfältig eingesetzt werden, um elektrische Energie auf unterschiedlichste Weise umzuformen. Die Umformung der elektrischen Energie wird in der Regel mittels eines Energiewandlers durchgeführt, der zum Beispiel als Wechselrichter ausgebildet sein kann.

Der Wechselrichter ist eine Form eines Energiewandlers, der einen Gleichspannungszwischenkreis mit einem Wechselspannungsnetz energietechnisch koppelt, so dass zwischen dem Gleichspannungszwischenkreis und dem Wechselspannungsnetz elektrische Energie ausgetauscht werden kann. Zu diesem Zweck ist in der Regel vorgesehen, dass der Energiewandler wenigstens ein Schaltelement aufweist, das mit elektrischen Energiespeichern zusammenwirkt. Das wenigstens eine Schaltelement ist in der Regel aus einem Halbleitermodul gebildet, das ein oder mehrere Halbleiterschaltelemente umfassen kann.

Wechselspannungsseitig kann das Wechselspannungsnetz zum Beispiel durch eine elektrische Maschine gebildet sein, insbesondere eine mehrphasige elektrische Maschine. Durch Steuern des wenigstens einen Schaltelements mittels einer Steuereinheit im Schaltbetrieb kann die gewünschte Wandlungsfunktion des Wechselrichters beziehungsweise des Energiewandlers erreicht werden, sodass mit der elektrischen Maschine die gewünscht Antriebsfunktion erreicht werden kann.

Zu diesem Zweck werden die Schaltelemente gewöhnlich mit einer vorgegebenen Taktrate betrieben, die erheblich größer als eine Frequenz von wenigstens einer Phasenwechselspannung des Wechselspannungsnetzes ist. Mittels bestimmter Steuerungsverfahren, wie Pulsweitenmodulation (PWM) oder dergleichen, kann dann die gewünschte energietechnische Kopplung hergestellt werden. Zu diesem Zweck stellt die Steuereinheit für das wenigstens eine Schaltelement beziehungsweise jedes der Schaltelemente spezifische Schaltsignale bereit, sodass das wenigstens eine Schaltelement beziehungsweise die Schaltelemente im Schaltbetrieb in gewünschter Weise betrieben werden können.

Es hat sich gezeigt, dass Halbleitermodule, insbesondere nach Art von Leistungsmodulen einer Alterung unterliegen, die unter anderem von einem Temperaturhub eines Halbleiterelements abhängig sind, der beispielsweise durch wechselnde elektrische Beanspruchung hervorgerufen werden kann. Nach einer bestimmten Anzahl von Temperaturzyklen in Bezug auf die Lastwechsel, wird ein Nutzbarkeitsende für eine bestimmungsgemäße Nutzbarkeit des Halbleitermoduls erreicht, und es kann zu einem Ausfall des Halbleitermoduls kommen. Dies kann unter anderem durch eine Zerrüttung von verschiedenen Aufbau- und Verbindungsschichten und einer damit einhergehenden schlechteren thermischen Anbindung des Halbleiterelements an die Kühleinrichtung begründet sein. Der Ausfall eines Halbleitermoduls, insbesondere eines Energiewandlers mit wenigstens einem Halbleitermodul, erweist sich als störend und kann unter Umständen sogar gefährliche Zustände zur Folge haben. Es ist daher gewünscht, Informationen über eine noch verbleibende bestimmungsgemäße Nutzbarkeit des Halbleitermoduls zur Verfügung zu haben, damit einerseits rechtzeitig vor Ausfall des Halbleitermoduls eine Wartung durchgeführt werden kann und andererseits die Wartung erst dann vorgenommen zu werden braucht, wenn das Nutzbarkeitsende absehbar ist.

Zu diesem Zweck ist es bisher üblich, eine Temperatur des Halbleiterelements über ein thermisches Modell zu ermitteln. Dabei wird von einer mittels eines Temperatursensors erfassten Temperatur an der Kühleinrichtung ausgegangen und rechnerisch unter Durchführung von Näherungen auf die tatsächliche Temperatur des Halbleiterelements geschlossen. Auf Basis der auf diese Weise errechneten Temperatur des Halbleiterelements kann ein jeweiliger Temperaturhub des Halbleiterelements geschätzt und gezählt werden. Durch empirische Versuche mittels Lastwechseltests in Bezug auf das wenigstens eine Halbleitermodul kann eine Anzahl von Temperaturzyklen bis zum Ausfall des Halbleitermoduls ermittelt werden. Diese Lastwechselfestigkeit wird für einen vorgegebenen, vergleichsweise großen Temperaturhub, beispielsweise größer als 70K, ermittelt.

Im bestimmungsgemäßen Betrieb des Halbleitermoduls treten in der Regel jedoch lediglich kleinere Temperaturhübe auf, beispielsweise in einem Bereich von etwa 10K bis etwa 35K. Nur vereinzelt kommt es zu größeren Temperaturhüben.

Das vorgenannte thermische Modell für das Ermitteln der noch verbleibenden Nutzbarkeit erweist sich insofern als nachteilig, als dass als Rechengröße eine aktuelle Verlustleistung berücksichtigt wird, welche über wenige hinterlegte Punkte rechnerisch ermittelt wird. Des Weiteren berücksichtigt dieses Modell nicht, dass sich ein thermischer Widerstand zwischen dem Halbleiterelement und der Kühlfläche mit fortschreitender Nutzung des Halbleitermoduls verändern kann, insbesondere vergrößern kann. Diese Punkte, die Messung der Lastwechselfähigkeit bei einem Temperaturhub von größer als 70K in Verbindung mit einer Chargenstreuung der Halbleitermodule, die begrenzte Genauigkeit der Ermittlung der aktuellen Verluste sowie die Veränderung des thermischen Widerstands abhängig von der bestimmungsgemäßen Nutzung führen zu einer sehr ungenauen Ermittlung des Nutzbarkeitsendes beziehungsweise der noch verbleibenden Nutzbarkeit. Die Wartung wird daher in der Regel deutlich vor dem Nutzbarkeitsende durchgeführt, obwohl tatsächlich noch genügend Abstand bis zum Nutzbarkeitsende vorliegen kann. Dies ist aufwendig und teuer.

Ferner offenbart die EP 3 054 306 A1 ein Verfahren zur Bestimmung einer Alterung von Leistungshalbleitermodulen sowie eine Vorrichtung und eine Schaltungsanordnung. Weiterhin offenbart die JP 2011-196703 A eine Leistungszykluslebensdauerschätzung für ein Leistungshalbleitermodul. Darüber hinaus offenbart die EP 3 203 250 A1 ein Verfahren und eine Vorrichtung zum Schätzen eines Beschädigungspegels oder einer Lebenserwartung eines Leistungshalbleitermoduls. Schließlich offenbart die US 2009/0046406 A1 eine Halbleitervorrichtung. Der Erfindung liegt die Aufgabe zugrunde, das Nutzbarkeitsende beziehungsweise eine verbleibende bestimmungsgemäße Nutzbarkeit des Halbleitermoduls genauer zu bestimmen.

Als Lösung werden mit der Erfindung Verfahren, Steuereinheiten sowie ein Energiewandler gemäß den unabhängigen Ansprüchen vorgeschlagen.

Vorteilhafte Weiterbildungen ergeben sich anhand von Merkmalen der abhängigen Ansprüche.

Bezüglich eines gattungsgemäßen Verfahrens wird gemäß einem ersten Aspekt vorgeschlagen, dass das Halbleitermodul bei einer vorgegebenen Kühlung durch die Kühleinrichtung mit einer vorgegebenen elektrischen Beanspruchung beaufschlagt wird, und Prognosedaten nach den im Anspruch 1 festgelegten Verfahrensschritten erstellt werden.

In Bezug auf ein gattungsgemäßes Verfahren wird gemäß einem zweiten Aspekt vorgeschlagen, dass das Halbleitermodul bei einer vorgegebenen Kühlung durch die Kühleinrichtung mit einer vorgegebenen elektrischen Beanspruchung beaufschlagt wird, und Prognosedaten nach den im Anspruch 3 festgelegten Verfahrensschritten erstellt werden.

Bezüglich eines gattungsgemäßen Verfahrens zum Betreiben eines Energiewandlers wird insbesondere vorgeschlagen, dass eine noch verbleibende bestimmungsgemäße Nutzbarkeit des wenigstens einen Halbleitermoduls gemäß der Erfindung bestimmt wird.

Weitere Aspekte der Erfindung beschreiben eine Steuereinheit nach Anspruch 10 und einen Energiewandler nach Anspruch 11.

Die Erfindung basiert auf dem Gedanken, dass durch eine nahezu unmittelbare beziehungsweise direkte Erfassung der Temperatur des Halbleiterelements gemäß dem ersten Aspekt beziehungsweise Ermitteln des thermischen Widerstands gemäß dem zweiten Aspekt die Prognosedaten erheblich genauer als bisher ermittelt werden können. Dabei können spezifische Eigenschaften des Halbleitermoduls beziehungsweise von dessen Halbleiterelement herangezogen werden, um die tatsächliche Temperatur des Halbleiterelements zu erfassen. So kann beispielsweise bei einem IGBT die Temperaturerfassung dadurch erreicht werden, indem die Threshold-Spannung des IGBT mittels eines Spannungssensors erfasst wird. Die Threshold-Spannung ist üblicherweise abhängig von der Temperatur des Halbleiterelements beziehungsweise des Halbleiterchips des IGBT. Darüber hinaus kann natürlich auch vorgesehen sein, dass das Halbleiterelement einen zum Beispiel integrierten PN-Übergang umfasst, der als Temperatursensor dienen kann. In diesem Zusammenhang wird unter anderem verwiesen auf die Veröffentlichung "Application issues of an online temperature estimation method in a high-power 4.5kV IGBT module based on the gateemitter threshold voltage" von Höher, M. et al., European Conference on Power Electronics and Applications, EPE 2016, ECCE Europe, Karlsruhe, Deutschland, September 2016.

Die Erfindung nutzt ferner die Erkenntnis, dass, insbesondere in Bezug auf den ersten Aspekt bei einer vorgegebenen elektrischen Beanspruchung und einer vorgegebenen Kühlung durch die Kühleinrichtung ein Anstieg der erfassten Temperatur beziehungsweise eines erfassten Temperaturhubes ein Maß für die Alterung und damit für die noch verbleibende bestimmungsgemäße Nutzbarkeit des Halbleitermoduls sein kann. Aus dieser Erkenntnis heraus kann ferner empirisch die Vergleichstemperatur ermittelt werden, die für die Durchführung des ersten Vergleichs herangezogen wird. Dies kann zum Beispiel durch Laborversuche, insbesondere unter Nutzung statistischer Methoden und/oder dergleichen erfolgen. Abhängig von dem Vergleich können dann die Prognosedaten für die noch verbleibende bestimmungsgemäße Nutzbarkeit des Halbleitermoduls bis zum Nutzbarkeitsende ermittelt werden. Die Prognosedaten können hierzu zum Beispiel abhängig von einer Differenz zwischen der erfassten Temperatur und der Vergleichstemperatur ermittelt werden. Gemäß dem ersten Aspekt wird also für die Ermittlung der Prognosedaten die erfasste Temperatur herangezogen.

Für den zweiten Aspekt wird die Erkenntnis genutzt, dass der thermische Widerstand zwischen dem Halbleiterelement und der Kühleinrichtung herangezogen werden kann, um die Prognosedaten zu ermitteln. Dabei wird die Erkenntnis genutzt, dass der thermische Widerstand ebenfalls von einer Alterung des Halbleitermoduls abhängig sein kann, weil der thermische Widerstand sich mit zunehmender Alterung des Halbleitermoduls erhöhen kann. Dies kann dazu genutzt werden, im Rahmen eines zweiten Vergleichs die Prognosedaten zu ermitteln. Zu diesem Zweck wird ein thermischer Referenzwiderstand ermittelt, der für den zweiten Vergleich zur Verfügung gestellt wird. Der thermische Referenzwiderstand kann ebenfalls durch Laborversuche, insbesondere unter Nutzung von statistischen Methoden und/oder dergleichen ermittelt werden. Damit ist es also möglich, wenn der thermische Widerstand zwischen dem Halbleiterelement und der Kühleinrichtung ermittelt worden ist, durch den zweiten Vergleich ebenfalls Prognosedaten zu ermitteln.

Dem Grunde nach können die beiden Aspekte natürlich auch kombiniert miteinander angewendet werden, um die Genauigkeit zu erhöhen oder um spezifische Anwendungen der Halbleitermodule besser berücksichtigen zu können.

Ein Halbleitermodul im Sinne dieser Offenbarung ist insbesondere auf eine mechanische Bauform des Halbleiterschaltelements gerichtet, bei der ein Halbleiterelement, welches beispielsweise durch einen Halbleiterchip oder dergleichen gebildet sein kann, mit einer Kühlfläche thermisch gekoppelt ist, die ihrerseits mit einer Kühleinrichtung gekoppelt werden kann, um während des bestimmungsgemäßen Betriebs des Schaltelements entstehende Wärme abführen zu können. Zu diesem Zweck ist das Halbleiterelement in der Regel mittels mechanischer Verbindungsverfahren und/oder mechanischer Verbindungsmittel mit der Kühlfläche fest verbunden, sodass ein möglichst günstiger thermischer Übergangswiderstand erreicht werden kann. Das Halbleitermodul kann somit wenigstens ein Halbleiterelement aufweisen. Je nach Bedarf kann das Halbleitermodul jedoch auch weitere Halbleiterelemente aufweisen, die dann entweder separate Kühlflächen aufweisen können oder zumindest teilweise gemeinsam mit einer einzigen Kühlfläche verbunden sein können. Häufig umfasst das Halbleitermodul ein Gehäuse, welches die Kühlfläche bereitstellt. Zugleich kann mit dem Gehäuse eine beispielsweise hermetische Abdichtung gegenüber einer äußeren Atmosphäre erreicht werden, so dass das Halbleiterelement beziehungsweise die Halbleiterelemente vor äußeren mechanischen und atmosphärischen Einwirkungen geschützt werden kann.

Der Energiewandler kann wenigstens ein einziges Halbleitermodul als Schaltelement umfassen. Je nach Bedarf können jedoch auch mehrere Halbleitermodule vorgesehen sein, um gewünschte Energiewandlungsfunktionalitäten realisieren zu können. Um die Energiewandler realisieren zu können, umfasst der Energiewandler in der Regel auch einen elektrischen Energiespeicher oder ist zumindest mit einem solchen elektrisch gekoppelt, beispielsweise einen oder mehrere Kondensatoren, eine oder mehrere elektrische Spulen und/oder dergleichen. Natürlich können auch Kombinationsschaltungen hiervon vorgesehen sein. Die Energiewandlungsfunktion des Energiewandlers wird mittels der Halbleitermodule in Zusammenwirkung mit dem wenigstens einen Energiespeicher realisiert.

Das wenigstens eine Halbleitermodul, welches wenigstens ein Schaltelement des Energiewandlers bildet, weist zur Realisierung der gewünschten Schaltfunktion jeweils wenigstens einen Steueranschluss auf, an dem es mit dem von der Steuereinheit bereitgestellten Schaltsignal beaufschlagbar ist, sodass die gewünschte Schaltfunktion des Halbleitermoduls realisiert werden kann. Das Schaltsignal kann ein binäres Schaltsignal sein, welches wenigstens zwei Zustandswerte einnehmen kann, um die gewünschten Schaltfunktionen des Halbleitermoduls bereitstellen zu können. Beispielsweise kann das Schaltsignal durch eine Impulsfolge gebildet sein, mittels der der Steueranschluss beaufschlagt wird. Dies ist vor allem bei Halbleitermodulen zweckmäßig, die Thyristoren und GTO umfassen. Darüber hinaus kann bei Transistoren vorgesehen sein, dass das Schaltsignal ein Rechtecksignal ist, wobei ein jeweiliger Schaltzustand des Schaltelements beziehungsweise des Halbleitermoduls einem der Potentiale des Rechtecksignals zugeordnet werden kann. Ein solches Signal ist beispielsweise für Transistoren, insbesondere für bipolare Transistoren, Feldeffekttransistoren oder dergleichen zweckmäßig.

Das Schaltelement im Sinne dieser Offenbarung, welches in der Regel als Halbleiterschaltelement ausgebildet ist, ist dabei vorzugsweise ein steuerbares elektronisches Schaltelement, beispielsweise ein steuerbarer elektronischer Halbleiterschalter wie zum Beispiel ein Transistor, der in einem Schaltbetrieb betrieben wird, ein Thyristor, Kombinationsschaltungen hiervon, vorzugsweise mit parallelgeschalteten Inversdioden, ein Gate-Turn-Off-Thyristor (GTO), ein Insulated-Gate-Bipolar-Transistor (IGBT), Kombinationen hiervon oder dergleichen. Dem Grunde nach kann das Schaltelement jedoch auch durch einen Feldeffekttransistor, insbesondere einen Metal-Oxide-Semiconductor-Field-Effect-Transistor (MOSFET) gebildet sein.

Zum Zwecke des Energiewandelns wird das wenigstens eine Halbleitermodul in der Regel in einem Schaltbetrieb betrieben. In Bezug auf einen Halbleiterschalter unter Nutzung eines Transistors bedeutet der Schaltbetrieb, dass in einem eingeschalteten Schaltzustand zwischen den eine Schaltstrecke bildenden Anschlüssen des Transistors ein sehr kleiner elektrischer Widerstand bereitgestellt wird, so dass ein hoher Stromfluss bei kleiner Restspannung möglich ist. In einem ausgeschalteten Schaltzustand ist hingegen die Schaltstrecke des Transistors hochohmig, das heißt, sie stellt einen hohen elektrischen Widerstand bereit, so dass auch bei hoher, an der Schaltstrecke anliegender elektrischer Spannung im Wesentlichen kein oder nur ein sehr geringer, insbesondere vernachlässigbarer Stromfluss vorliegt. Hiervon unterscheidet sich ein Linearbetrieb bei Transistoren, der aber bei Energiewandlern der gattungsgemäßen Art in der Regel nicht zum Einsatz kommt.

Die Steuereinheit stellt die Funktionalität zum Erzeugen der Schaltsignale bereit. Auch weitere Funktionen, insbesondere in Bezug auf den Energiewandler können durch die Steuereinheit realisiert sein, beispielsweise Überwachungsfunktionen, Sicherheitsfunktionen und/oder dergleichen. Zu diesem Zweck kann die Steuereinheit eine Hardwareschaltung und/oder eine programmgesteuerte Rechnereinheit oder dergleichen umfassen. Natürlich kann die Steuereinheit als eine separate Baugruppe ausgebildet sein. Die Steuereinheit kann jedoch auch zumindest teilweise von einer übergeordneten Steuerung des Energiewandlers oder der Antriebseinrichtung, die den Energiewandler umfasst, umfasst sein.

Die elektrische Maschine kann eine Gleichspannungsmaschine oder auch eine Wechselspannungsmaschine sein. Als Wechselspannungsmaschine kann die elektrische Maschine eine ein- oder auch eine mehrphasige Wechselspannungsmaschine sein. Die elektrische Maschine kann zum Beispiel eine Synchronmaschine, eine Asynchronmaschine oder dergleichen sein. Ist die elektrische Maschine eine Synchronmaschine, kann sie zum Beispiel als permanenterregte Synchronmaschine ausgebildet sein. Sie kann jedoch auch als fremderregte Synchronmaschine oder dergleichen ausgebildet sein. Natürlich kommen auch Kombinationen hiervon in Betracht, um beispielsweise bestimmte Antriebsfunktionen realisieren zu können, die eine Beeinflussung des magnetischen Flusses wünschen lassen.

Die Taktrate entspricht im Wesentlichen einer Frequenz, mit der die Schaltsignale für das wenigstens eine Halbleitermodul durch die Steuereinheit bereitgestellt werden. Dabei kann vorgesehen sein, dass ein Impuls für das Steuern eines einzelnen Schaltelements synchronisiert mit der Taktrate einen Einschaltzeitraum und einen Ausschaltzeitraum für das Schaltelement bereitstellt.

Das wenigstens eine Halbleitermodul ist in der Regel als Leistungshalbleitermodul, gelegentlich auch Leistungsmodul genannt, ausgebildet, weshalb eine Kühlung durch die Kühleinrichtung im bestimmungsgemäßen Betrieb gewünscht ist. Je nach elektrischer Beanspruchung des Halbleitermoduls im bestimmungsgemäßen Betrieb wird Wärme im Halbleitermodul erzeugt, die mittels der Kühleinrichtung abgeführt wird, um eine thermische Überbeanspruchung des Halbleitermoduls zu vermeiden. Die Wärme entsteht beim Halbleitermodul im bestimmungsgemäßen Betrieb unter anderem dadurch, dass ein elektrischer Strom geführt wird und somit Durchlassverluste entstehen. Darüber hinaus entsteht die Wärme unter anderem auch dadurch, dass während des Wechselns zwischen einem eingeschalteten Schaltzustand und einen ausgeschalteten Schaltzustand Schaltverluste entstehen.

Die Prognosedaten können dazu genutzt werden, eine entsprechende Angabe zum Informieren eines Nutzers bereitzustellen. Durch die Angabe kann der Nutzer darüber informiert werden, welche voraussichtliche Nutzungsdauer beziehungsweise noch verbleibende bestimmungsgemäße Nutzbarkeit für das Halbleitermodul noch zur Verfügung steht. Darüber hinaus kann die Angabe dazu dienen, eine Wartung zu planen, sodass das Halbleitermodul möglichst umfänglich bis zum Nutzbarkeitsende genutzt werden kann und rechtzeitig vor einem Ausfall des Halbleitermoduls eine entsprechende Wartung durchgeführt werden kann. Dadurch können Kosten für die Wartung und den Betrieb des Halbleitermoduls sowie auch von Einrichtungen, die das Halbleitermodul nutzen, wie beispielsweise der Energiewandler oder dergleichen, reduziert werden.

Die Prognosedaten sind vorzugsweise durch zum Beispiel ein elektrisches Signal gebildet. Die Prognosedaten können beispielsweise digitale Daten umfassen. Dem Grunde nach können sie jedoch auch analoge Daten umfassen. Die Prognosedaten können durch eine Auswerteeinheit der Steuereinheit ermittelt beziehungsweise bestimmt werden. Zu diesem Zweck kann die Auswerteeinheit zum Beispiel eine elektronische Schaltung, eine programmgesteuerte Recheneinrichtung, Kombinationen hiervon oder dergleichen umfassen. Die Auswerteeinheit kann als separate Baugruppe der Steuereinheit ausgebildet sein. Sie kann dem Grunde nach aber auch von einer übergeordneten Steuereinheit umfasst sein, die beispielsweise die Einrichtung, die das Halbleitermodul umfasst, steuert.

Um die Prognosedaten zu ermitteln, wird das Vergleichsergebnis zumindest des ersten Vergleichs und/oder des zweiten Vergleichs für die Steuereinheit, und hier insbesondere für die Auswerteeinheit, zur Verfügung gestellt. Zu diesem Zweck kann ein Vergleichssignal bei der Durchführung eines jeweiligen der Vergleiche durch die Auswerteeinheit ausgewertet werden, um die Prognosedaten zu ermitteln. Das Ermitteln der Prognosedaten kann ergänzend unter Nutzung von statistischen Methoden erfolgen. Zu diesem Zweck können Mittelwerte, Varianzen und/oder dergleichen ermittelt werden. Hierzu können ferner weitere Referenzdaten genutzt werden, die zum Beispiel in einer Speichereinheit der Steuereinheit, insbesondere der Auswerteeinheit gespeichert sein können. Darüber hinaus können diese Referenzdaten natürlich auch zumindest teilweise von einer externen Speichereinrichtung über eine Kommunikationsverbindung zwischen dieser Speichereinrichtung und der Steuereinheit beziehungsweise der Auswerteeinheit bereitgestellt sein. Hierdurch besteht die Möglichkeit, die Referenzdaten zentral bereitzustellen, so dass sie auf einfache Weise gewartet beziehungsweise aktualisiert werden können. Darüber hinaus können die Referenzdaten dann auch für eine Mehrzahl von unterschiedlichen Steuereinheiten beziehungsweise Auswerteeinheiten bereitgestellt werden. Die Referenzdaten können zum Beispiel unter Nutzung von einem oder mehreren Referenzhalbleitermodulen ermittelt sein. Diese können zum Beispiel im Rahmen von Laboruntersuchungen ermittelt werden. Natürlich können die unterschiedlichen Möglichkeiten zum Ermitteln der Prognosedaten auch miteinander kombiniert vorgesehen sein.

Die zu den Prognosedaten entsprechende Angabe kann zum Beispiel ein elektrisches, optisches, hydraulisches, pneumatisches oder auch haptisches Signal sein. Die Angabe kann auch eine Kombination von einem oder mehreren der vorgenannten Signale sein. Die Angabe kann aus den Prognosedaten ermittelt werden, indem die Prognosedaten einer Verarbeitungseinheit, beispielsweise einem Meldegerät oder dergleichen, zugeführt werden, welches dann abhängig hiervon die entsprechende Angabe derart ermittelt, dass abhängig von der entsprechenden Angabe eine für einen Nutzer wahrnehmbare Anzeige der zugeordneten Information bereitgestellt werden kann. Insbesondere kann die entsprechende Angabe eine prognostizierte Anzahl von Temperaturwechseln des Halbleiterelements und/oder einen prognostizierten Zeitraum für die noch verbleibende bestimmungsgemäße Nutzbarkeit bereitgestellt werden. Beispielsweise kann der thermische Referenzwiderstand zum Beginn einer bestimmungsgemäßen Nutzbarkeit des Halbleitermoduls ermittelt werden. Erreicht der ermittelte thermische Widerstand einen Wert, der den thermischen Referenzwiderstand um beispielsweise etwa 20% überschreitet, kann ein unmittelbar bevorstehendes Nutzbarkeitsende die Folge sein. Entsprechend werden die Prognosedaten ermittelt.

Die Verarbeitungseinheit beziehungsweise das Meldegerät kann von der Steuereinheit umfasst sein. Es kann jedoch auch als separate Verarbeitungseinheit beziehungsweise als separates Meldegerät ausgebildet sein, welches mit der Steuereinheit in Kommunikationsverbindung steht. Natürlich können auch Kombinationen hiervon vorgesehen sein. Die Verarbeitungseinheit beziehungsweise das Meldegerät verarbeiten die Prognosedaten derart, dass die gewünschte entsprechende Angabe beziehungsweise Darstellung der Information erreicht werden kann. Dies kann vom Meldegerät abhängig sein, und zwar insbesondere davon, welches Medium das Meldegerät für die Darstellung der Information nutzt. So kann das Meldegerät zum Beispiel für eine optische, akustische und/oder haptische Ausgabe der Information ausgebildet sein, wobei die Prognosedaten in geeigneter Weise verarbeitet werden, damit die gewünschte Ausgabe der Information erreicht werden kann. Dabei kann vorgesehen sein, dass die Art der Ausgabe der Information durch den Nutzer eingestellt werden kann, beispielsweise wenn das Meldegerät unterschiedliche Ausgabemöglichkeiten zur Verfügung stellt. Zu diesem Zweck können entsprechende Eingabemittel vorgesehen sein, die es erlauben, eine entsprechende Einstellung durch den Nutzer vornehmen zu können.

Die Steuereinheit kann als separate Baugruppe ausgebildet sein, die ein eigenes Gehäuse umfassen kann. Vorzugsweise ist die Steuereinheit jedoch Bestandteil einer übergeordneten Steuerung einer Einrichtung, die das Halbleitermodul nutzt, beispielsweise des Energiewandlers oder dergleichen.

Um die Prognosedaten zu ermitteln, wird das Halbleitermodul bei einer vorgegebenen Kühlung durch die Kühleinrichtung mit der vorgegebenen elektrischen Beanspruchung beaufschlagt. Durch die vorgegebene elektrische Beanspruchung kann ein entsprechender vorgegebener Betriebszustand erreicht werden, sodass eine entsprechende Verlustleistung des Halbleitermoduls ermittelt werden kann. Der Verlustleistung kann eine Wärmeleistung zugeordnet werden, die entsprechend durch die Kühleinrichtung abzuführen ist, um den bestimmungsgemäßen Betrieb des Halbleitermoduls zu gewährleisten. Zu diesem Zweck kann vorgesehen sein, dass die vorgegebene elektrische Beanspruchung vorgegebene Schaltmuster mit einer vorgegebenen Spannungs- und/oder Strombeanspruchung umfasst. Dadurch können definierte Rahmenbedingungen zum Erfassen der Temperatur beziehungsweise des thermischen Widerstands erreicht werden, um den jeweiligen entsprechenden Vergleich bestimmungsgemäß durchführen zu können.

Die bestimmungsgemäße Nutzbarkeit umfasst insbesondere die bestimmungsgemäße Nutzung des Halbleitermoduls zur Durchführung der elektrischen Steuerungsfunktion, beispielsweise als Schaltelement im Energiewandler, als Schaltelement in einer Energieverteilung und/oder dergleichen. Dabei bezieht sich die bestimmungsgemäße Nutzbarkeit darauf, dass das Halbleitermodul während des bestimmungsgemäßen Betriebs der Einrichtung, welches das Halbleitermodul umfasst, in einem bestimmungsgemäßen Betriebsbereich (englisch: safe operating area; SOA) betrieben wird. Bei dieser Angabe handelt es sich in der Regel um eine Herstellerangabe. Entsprechend ist das Nutzbarkeitsende für die bestimmungsgemäße Nutzbarkeit des Halbleitermoduls vorzugsweise dadurch gekennzeichnet, dass unter den Betriebsbedingungen gemäß SOA die gewünschte beziehungsweise erforderliche Funktion des Halbleitermoduls nicht mehr zuverlässig bereitgestellt werden kann, beispielsweise weil das Halbleitermodul aufgrund eines Ausfalls des Halbleiterelements nicht mehr einsatzbereit ist oder dergleichen.

Vorzugsweise wird vorgeschlagen, dass die elektrische Beanspruchung des Halbleitermoduls und die Kühlung während des bestimmungsgemäßen Betriebs erfasst werden und der Vergleich durchgeführt wird, sobald die vorgegebene elektrische Beanspruchung bei der vorgegebenen Kühlung ermittelt wird. Dadurch ist es möglich, die Prognosedaten auch während des bestimmungsgemäßen Betriebs des Halbleitermoduls zu ermitteln. Dabei basiert diese Weiterbildung auf dem Gedanken, dass die vorgegebene Beanspruchung und die vorgegebene Kühlung im bestimmungsgemäßen Betrieb zu bestimmten Zeitpunkten, die auch vorgegeben sein können, wiederholt auftreten können. Dadurch braucht zum Ermitteln der Prognosedaten für diesen Fall kein separates Testsignal für die bestimmungsgemäße Beanspruchung und die bestimmungsgemäße Kühlung vorgesehen zu werden. Ferner kann bei dieser Weiterbildung der bestimmungsgemäße Betrieb insgesamt ungestört weitergeführt werden.

Gemäß einer Weiterbildung wird vorgeschlagen, dass die Kühlung durch die Kühleinrichtung und die elektrische Beanspruchung außerhalb des bestimmungsgemäßen Betriebs vorgegeben wird. Hierdurch kann erreicht werden, dass die Prognosedaten zu einem vorgebbaren Zeitpunkt ermittelt werden können. Dies kann zum Beispiel vor einer Durchführung eines bestimmungsgemäßen Betriebs erfolgen oder auch bei einer Betriebsunterbrechung beziehungsweise einer Betriebspause. Diese Ausgestaltung eignet sich insbesondere dann, wenn während des bestimmungsgemäßen Betriebs des Halbleitermoduls die vorgegebene elektrische Beanspruchung und/oder die vorgegebene elektrische Kühlung nicht oder nur sehr selten erreicht werden.

Es wird weiterhin vorgeschlagen, dass die bezüglich der vorgegebenen Beanspruchung bei der vorgegebenen Kühlung erfasste Temperatur und/oder der ermittelte thermische Widerstand gespeichert wird. Dadurch ist es möglich, die Alterung des Halbleitermoduls zu dokumentieren und zugleich die Vergleichstemperatur beziehungsweise den thermischen Referenzwiderstand durch ergänzendes Auswerten genauer zu ermitteln, so dass insgesamt das Ermitteln der Prognosedaten weiter verbessert werden kann. Darüber hinaus besteht hierdurch die Möglichkeit, zum Beispiel in die Kühleinrichtung einzugreifen und eine Kühlungsfunktion zu verstärken, so dass aufgrund von Alterungseffekten eine erhöhte Temperatur des Halbleiterelements reduziert werden kann. Dadurch kann die bestimmungsgemäße Nutzung des Halbleitermoduls insgesamt vergrößert werden. Vorzugsweise sind in diesem Fall die Vergleichstemperatur und/oder der thermische Referenzwiderstand entsprechend anzupassen.

Vorzugsweise werden die Prognosedaten ermittelt, bevor ein Nutzbarkeitsende für eine bestimmungsgemäße Nutzbarkeit des Halbleitermoduls erreicht ist. Dadurch kann durch die Prognosedaten eine prognostizierte noch verfügbare Nutzbarkeit des Halbleitermoduls mittels einer entsprechenden Angabe angezeigt werden. Der Nutzer kann somit, vorzugsweise kontinuierlich, über die noch verbleibende bestimmungsgemäße Nutzbarkeit informiert sein, so dass gegebenenfalls spezifische Einsatzszenarien, die eine zuverlässige Funktion des Halbleitermoduls erfordern, entsprechend geplant werden können. Die Prognosedaten werden also nicht nur zum Nutzbarkeitsende ermittelt.

Weiterhin wird vorgeschlagen, dass bei einer Differenz zwischen der erfassten Temperatur und der Vergleichstemperatur und/oder einer Differenz zwischen dem ermittelten thermischen Widerstand und dem thermischen Referenzwiderstand, die größer als ein vorgegebener Referenzwert ist, das Nutzbarkeitsende angezeigt wird. Dadurch kann erreicht werden, dass ein möglicherweise gefährlicher Ausfall des Halbleitermoduls vorher durch eine Wartung behoben werden kann. Beispielsweise kann zu diesem Zweck das Halbleitermodul getauscht werden. Besonders bei sicherheitsrelevanten Nutzungen des Halbleitermoduls kann dies von Vorteil sein. Der Referenzwert kann beispielsweise durch Laborversuche oder dergleichen empirisch ermittelt worden sein. Darüber hinaus kann der Referenzwert auch unter Berücksichtigung statistischer Auswertemethoden ermittelt worden sein.

Gemäß einer Weiterbildung wird vorgeschlagen, dass abhängig von der Differenz zwischen der erfassten Temperatur und der Vergleichstemperatur und/oder der Differenz zwischen dem ermittelten thermischen Widerstand und dem thermischen Referenzwiderstand ein Beanspruchungssignal zum Einstellen einer maximalen Beanspruchung des Halbleitermoduls ausgegeben wird. Hierdurch kann zum Beispiel ein Beanspruchungs-Derating durch die Steuereinheit realisiert werden, wodurch die Nutzbarkeit der Einrichtung, die das Halbleitermodul umfasst, vergrößert werden kann. Das Nutzbarkeitsende kann somit hinausgeschoben werden. Darüber hinaus kann auch erreicht werden, dass ein Notbetrieb aufrechterhalten werden kann, bis eine Wartung durchgeführt werden kann, um zum Beispiel das Halbleitermodul zu tauschen. Insgesamt kann die Zuverlässigkeit hierdurch verbessert werden.

Dient als Halbleitermodul in einem Energiewandler dazu, eine elektrische Maschine mit einem Gleichspannungszwischenkreis elektrisch zu koppeln, kann ergänzend vorgesehen sein, dass die elektrische Maschine gemäß einer Vektorsteuerung gesteuert und als vorgebbare elektrische Beanspruchung ein ausschließlich feldbildender Strom bezüglich der elektrischen Maschine eingestellt wird. Hierdurch kann erreicht werden, dass in kurzer Zeit eine hohe thermische Beanspruchung des Halbleiterelements erreicht werden kann. Zum Ermitteln der Prognosedaten kann dann die erfasste Temperatur und/oder der ermittelte thermische Widerstand genutzt werden, so wie zuvor bereits erläutert. Die Prognosedaten können also in diesem Fall bei einer bestehenden Einrichtung beziehungsweise Anwendung ermittelt werden, ohne dass diesbezüglich zusätzliche Eingriffe erforderlich wären. Besonders vorteilhaft erweist es sich, dass durch den feldbildenden Strom die elektrische Maschine kein Drehmoment zu erzeugen braucht, so dass keine unerwünschten Wirkungen durch die elektrische Maschine die Folge sind.

Vorzugsweise wird der feldbildende Strom außerhalb eines bestimmungsgemäßen Betriebs der elektrischen Maschine eingestellt. Dadurch ist es möglich, die Bedingungen, die vorgegebene elektrische Beanspruchung und die vorgegebene Kühlung nahezu frei einzustellen, weil ein Betrieb der elektrischen Maschine nicht berücksichtigt zu werden braucht. Die Nutzung des erfindungsgemäßen Verfahrens kann dadurch verbessert werden.

Weitere Merkmale, Vorteile und Wirkungen ergeben sich aus dem folgenden Ausführungsbeispiel anhand der Figuren. In den Figuren bezeichnen gleiche Bezugszeichen gleiche Merkmale und Funktionen. Es zeigen:
- FIG 1: eine schematische Schaltbilddarstellung einer Antriebseinrichtung mit einer an einem Wechselrichter angeschlossenen Asynchronmaschine,
- FIG 2: eine schematische Schnittdarstellung eines an einem Kühlkörper angeordneten IGBT-Moduls in einer schematischen Schnittansicht, und
- FIG 3: eine schematische Diagrammdarstellung für eine vorgegebene elektrische Beanspruchung des IGBT-Moduls gemäß FIG 2 sowie von entsprechenden Temperaturen, und
- FIG 4: ein schematisches Flussdiagramm für eine erfindungsgemäße Verfahrensführung.

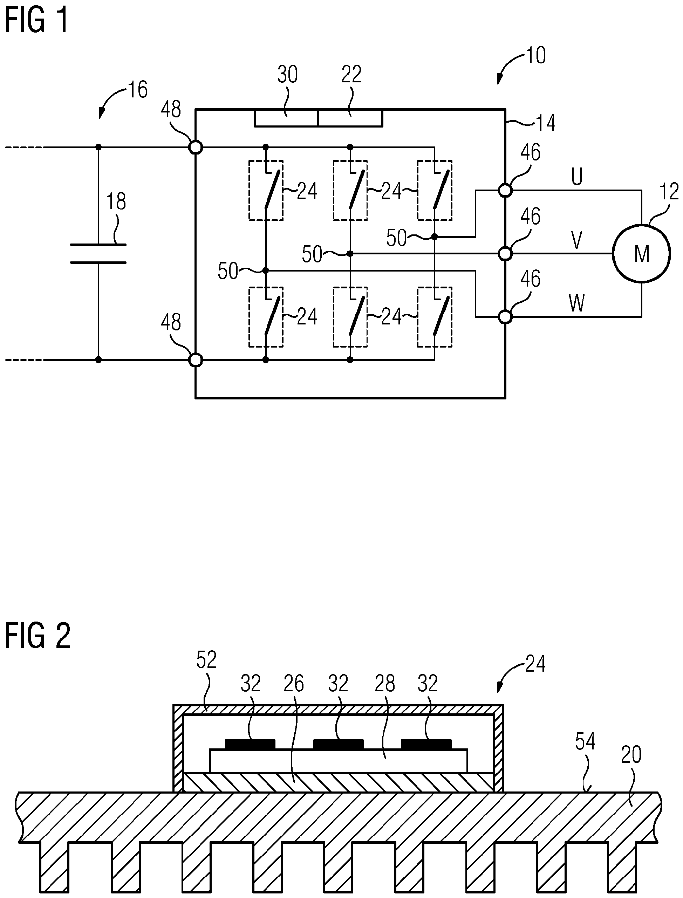

FIG 1 zeigt in einer schematischen Schaltbilddarstellung eine Antriebseinrichtung 10 mit einem Wechselrichter 14 als Energiewandler, der drei Anschlusskontakte 46 zum Anschließen einer dreiphasigen Asynchronmaschine 12 umfasst. Die Asynchronmaschine 12 umfasst die Phasen U, V, W. Der Wechselrichter 14 umfasst ferner Anschlusskontakte 48, über die er an einen Gleichspannungszwischenkreis 16 angeschlossen ist, der einen Zwischenkreiskondensator 18 aufweist. Die Anschlusskontakte 48 bilden einen Zwischenkreisanschluss.

Der Wechselrichter 14 weist IGBT-Module 24 als Halbleitermodule beziehungsweise Schaltelemente auf, die in bekannter Weise in paarweisen Reihenschaltungen geschaltet sind, deren Mittelanschlüsse 50 an die entsprechenden Anschlusskontakte 46 angeschlossen sind.

Der Wechselrichter 14 umfasst ferner eine Steuereinheit 22, die Schaltsignale für die IGBT-Module 24 bereitstellt, damit diese in einem Schaltbetrieb betrieben werde. Dadurch kann die Asynchronmaschine 12 mit dem Gleichspannungszwischenkreis 16 in vorgebbarer Weise gekoppelt werden.

An die Steuereinheit 22 ist ferner eine Anzeigeeinheit 30 angeschlossen, über die Betriebsparameter und aktuelle Betriebsdaten der Antriebseinrichtung 10, insbesondere des Wechselrichters 14 angezeigt werden können.

FIG 2 zeigt einen schematischen mechanischen Aufbau eines der IGBT-Module 24, wie es beim Wechselrichter 14 gemäß FIG 1 eingesetzt ist. Die Darstellung der FIG 2 ist eine Schnittdarstellung. Zu erkennen ist, dass das IGBT-Modul 24 ein Gehäuse 52 aufweist, welches eine Montageplatte 26 umfasst. Die Montageplatte 26 ist vorliegend an eine Verbindungsfläche 54 eines Kühlkörpers 20 angeschlossen, der eine Kühleinrichtung bereitstellt. Durch den Kühlkörper 20 wird eine vorgegebene Kühlung erreicht.

Um eine möglichst gute Wärmeabfuhr bezüglich des IGBT-Moduls 24 zu erreichen, sind die Montageplatte 26 und die Verbindungsfläche 54 angepasst zueinander ausgebildet. Dadurch kann ein besonders günstiger beziehungsweise kleiner thermischer Übergangswiderstand erreicht werden. Die Montageplatte 26 stellt somit eine Kühlfläche bereit.

Gehäuseinnenseitig ist auf der Montageplatte 26 oberhalb eines nicht weiter dargestellten Schichtaufbaus ein Halbleiterelement 28 befestigt. Der Schichtaufbau dient der thermischen und mechanischen Verbindung des Halbleiterelements 28 mit der Montageplatte 26.

Das Halbleiterelement 28 stellt den eigentlichen IGBT bereit. Bezüglich des Halbleiterelements 28 und der Montageplatte 26 ist ein vorgegebener thermischer Übergangswiderstand bereitgestellt.

Zu erkennen ist ferner, dass das Halbleiterelement 28 gegenüberliegend zur Montageplatte 26 Kontaktflächen 32 aufweist, die mittels eines bekannten Bondings mit entsprechenden nicht dargestellten Anschlusskontakten des IGBT-Moduls 24 verbunden sind. Auf diese Weise kann eine mechanische Verbindung und ein entsprechender elektrischer Anschluss erreicht werden.

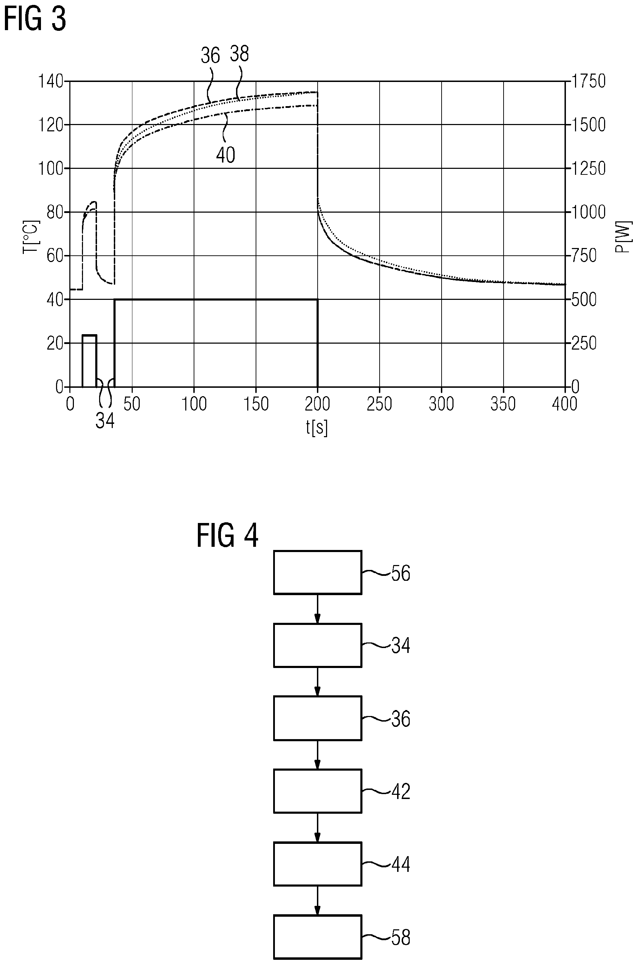

Um nun noch eine verbleibende bestimmungsgemäße Nutzbarkeit des IGBT-Moduls 24 ermitteln zu können, werden sowohl die Kühlung durch den Kühlkörper 20 als auch die elektrische Beanspruchung der IGBT-Module 24 überwacht. Wird eine vorgegebene elektrische Beanspruchung gemäß dem Graphen 34 (FIG 3) ermittelt, werden zugleich die entsprechenden Temperaturen der Halbleiterelemente 28 der Halbleitermodule 24 gemäß Graphen 36 (FIG 3) erfasst. Zuvor wurde bereits eine Vergleichstemperatur gemäß dem Graphen 40 für die vorgegebene elektrische Beanspruchung gemäß dem Graphen 34 ermittelt.

In einem Vergleich, der durch die Steuereinheit 22 durchgeführt wird, wird die erfasste Temperatur gemäß dem Graphen 36 mit der Vergleichstemperatur gemäß dem Graphen 40 verglichen. Abhängig von dem Vergleich werden dann Prognosedaten (FIG 4) ermittelt, die von der Anzeigeeinheit 30 verarbeitet werden, sodass die Anzeigeeinheit 30 die noch verbleibende Nutzbarkeit als noch verbleibenden Nutzungszeitraum angibt.

Im vorliegenden Fall für die IGBT-Module 24 wird die Temperatur durch Messen der Threshold-Spannung der IGBT-Module 24 ermittelt. Bekanntermaßen ist diese Spannung von der Temperatur der jeweiligen Halbleiterchips abhängig, sodass aus der ermittelten Werten dieser Spannung die tatsächlichen Temperaturen der Halbleiterelemente 28 ermittelt werden können. Im vorliegenden Fall sind die Prognosedaten 44 (FIG 4) somit abhängig von einer Differenz zwischen der erfassten Temperatur gemäß dem Graphen 36 und der Vergleichstemperatur gemäß dem Graphen 40. Die Vergleichstemperatur kann unter Nutzung von Modellen, statistischen Auswertungsmethoden und Laborversuchen ermittelt werden.

Aus FIG 3 ist ferner ersichtlich, wie sich die erfasste Temperatur verhält, wenn die Kühlung durch die Kühleinrichtung, hier den Kühlkörper 20, gestört ist, weil beispielsweise ein Luftfilter zugesetzt ist oder dergleichen. Dies ist anhand des Graphen 38 dargestellt. Zu erkennen ist, dass in diesem Fall eine Anstiegsgeschwindigkeit kleiner ist als mit dem Graphen 36 dargestellt. Dadurch ist die Steuereinheit 22 in der Lage zu erkennen, ob eine Kühlung durch den Kühlkörper 20 noch ausreicht oder sogar gestört ist. Dies kann die Steuereinheit 22 somit von den der Alterung zuordbaren Prognosedaten 44 unterscheiden.

FIG. 3 zeigt eine schematische Diagrammdarstellung, bei der die Abszisse der Zeit in Sekunden zugeordnet ist. Eine linke Ordinate ist der Temperatur in Grad Celsius und eine rechte Ordinate ist der Leistung in Watt zugeordnet. Ein Graph 34 stellt die vorgegebene elektrische Beanspruchung eines jeweiligen der IGBT-Module 24 dar. Zu erkennen ist, dass die vorgegebene elektrische Beanspruchung vorliegend zwei Rechteckimpulse umfasst, wobei der zeitlich erste Rechteckimpuls ein vergleichsweise zeitlich kurz andauernder Rechteckimpuls mit einer Leistung von etwa 300 Watt ist. Daran schließt sich nach einer kurzen Leistungspause ein zweiter Rechteckimpuls an, der sich über einen Zeitraum von etwa 160 s erstreckt und eine Leistung von etwa 500 W bereitstellt. Diese vorgegebene elektrische Beanspruchung führt zu einer Temperatur des Halbleiterelements 28 des IGBT-Moduls 24 gemäß dem Graphen 36.

Die entsprechende Vergleichstemperatur für eine derartige Beanspruchung für ein IGBT-Modul 24, welches neuwertig ist, ergibt sich anhand des Graphen 40. Zu erkennen ist, dass mit zunehmender Alterung der Abstand zwischen den Graphen 36 und 40 größer wird. Wird ein vorgegebener maximaler Abstand zwischen den Graphen 36 und 40 erreicht beziehungsweise überschritten, wird dies als Nutzbarkeitsende ermittelt. Aus der Differenz beziehungsweise dem Abstand zwischen den Graphen 36 und 40 kann somit auf die noch verbleibende bestimmungsgemäße Nutzbarkeit geschlossen werden beziehungsweise prognostiziert werden. Zu diesem Zweck umfasst die Steuereinheit 22 eine nicht weiter dargestellte Auswerteeinheit, die unter Nutzung statistischer Methoden die noch verbleibende bestimmungsgemäße Nutzbarkeit ermittelt und eine entsprechende Angabe als Signal für die Anzeigeeinheit 30 bereitstellt. Diese wertet das bereitgestellte Signal aus und stellt eine entsprechende Ausgabe einer Information für einen Nutzer bereits.

FIG 4 zeigt ein schematisches Flussdiagramm für die erfindungsgemäße Verfahrensführung. Das Verfahren beginnt im Schritt 56. Es wird eine vorgegebene elektrische Beanspruchung im entsprechenden Schritt 34 erfasst. Im Schritt 36 wird dann die zeitgleich die Temperatur der IGBT-Module 24 erfasst. Sodann wird die erfasste Temperatur in einem Vergleichsschritt 42 mit der Vergleichstemperatur 40 verglichen. Im folgenden Schritt 44 werden dann abhängig von dem Vergleich die Prognosedaten ermittelt. Das Verfahren endet im Schritt 58.

Mit der Erfindung kann ein Anlagenbetreiber der Antriebseinrichtung 10 dahingehend zuverlässiger gewarnt werden, als dass demnächst ein Ausfall eines Leistungshalbleiters, hier eines der IGBT-Module 24, bevorstehen kann. Somit kann eine entsprechende Wartung rechtzeitig geplant werden, sodass größere Schäden und längere Ausfallzeiten des Wechselrichters 14 vermieden werden können. Dadurch, dass der Ausfall eines der IGBT-Module 24 rechtzeitig erkannt werden kann, können größere weitere Schäden der Antriebseinrichtung 10, insbesondere am Wechselrichter 14 weitgehend vermieden werden.

Das vorliegende Ausführungsbeispiel dient ausschließlich der Erläuterung der Erfindung und soll diese nicht beschränken. Der Schutzumfang der Erfindung wird durch die folgenden Patentansprüche festgelegt.

## Patentansprüche

1. Verfahren zum Betreiben eines an eine elektrische Maschine (12) anschließbaren Energiewandlers (14), der dazu eingerichtet ist, die elektrische Maschine (12) mit einem Gleichspannungszwischenkreis (16) elektrisch zu koppeln, zu welchem Zweck wenigstens ein mit einer Kühleinrichtung (20) thermisch gekoppeltes Halbleitermodul (24) mit wenigstens einem mit dem Halbleitermodul (24) elektrisch gekoppelten Energiespeicher (18) zusammenwirkt und zum elektrischen Koppeln des Gleichspannungszwischenkreises (16) mit der elektrischen Maschine (12) in einem vorgebbaren Schaltbetrieb betrieben wird, wobei eine noch verbleibende bestimmungsgemäße Nutzbarkeit des wenigstens einen Halbleitermoduls (24) dadurch bestimmt wird, dass:
- das Halbleitermodul (24) bei einer vorgegebenen Kühlung durch die Kühleinrichtung (20) im bestimmungsgemäßen Betrieb mit einer vorgegebenen elektrischen Beanspruchung (34) beaufschlagt wird, wobei die vorgegebene elektrische Beanspruchung vorgegebene Schaltmuster mit einer vorgegebenen Spannungs- und/oder Strombeanspruchung umfasst,
- eine Temperatur (36) eines Halbleiterelements (28) des Halbleitermoduls (24) zumindest für die vorgegebene elektrische Beanspruchung (34) des Halbleitermoduls (24) erfasst wird,
- die erfasste Temperatur (36) in einem ersten Vergleich mit einer Vcrgleichstemperatur (40) verglichen wird, wobei die Vergleichstemperatur (40) der vorgegebenen elektrischen Beanspruchung (34) bei der vorgegebenen Kühlung zugeordnet ist, und
- Prognosedaten (44) für die noch verbleibende bestimmungsgemäße Nutzbarkeit des Halbleitermoduls (24) bis zu einem Nutzbarkeitsende zumindest abhängig von dem ersten Vergleich ermittelt werden,
wobei die elektrische Beanspruchung (34) des Halbleitermoduls (24) und die Kühlung während des bestimmungsgemäßen Betriebs erfasst werden und der Vergleich durchgeführt wird, sobald die vorgegebene elektrische Beanspruchung (34) bei der vorgegebenen Kühlung ermittelt wird, wobei die elektrische Maschine (12) gemäß einer Vektorsteuerung gesteuert und als vorgebbare elektrische Beanspruchung (34) ein ausschließlich feldbildender Strom bezüglich der elektrischen Maschine (12) eingestellt wird.

2. Verfahren nach Anspruch 1, **dadurch gekennzeichnet, dass** ein thermischer Widerstand zwischen dem Halbleiterelement (24) und der Kühleinrichtung (20) ermittelt wird und der ermittelte thermische Widerstand in einem zweiten Vergleich mit einem thermischen Referenzwiderstand verglichen wird, wobei die Prognosedaten (44) ergänzend abhängig vom zweiten Vergleich ermittelt werden.

3. Verfahren zum Betreiben eines an eine elektrische Maschine (12) anschließbaren Energiewandlers (14), der dazu eingerichtet ist, die elektrische Maschine (12) mit einem Gleichspannungszwischenkreis (16) elektrisch zu koppeln, zu welchem Zweck wenigstens ein mit einer Kühleinrichtung (20) thermisch gekoppeltes Halbleitermodul (24) mit wenigstens einem mit dem Halbleitermodul (24) elektrisch gekoppelten Energiespeicher (18) zusammenwirkt und zum elektrischen Koppeln des Gleichspannungszwischenkreises (16) mit der elektrischen Maschine (12) in einem vorgebbaren Schaltbetrieb betrieben wird, wobei eine noch verbleibende bestimmungsgemäße Nutzbarkeit des wenigstens einen Halbleitermoduls (24) dadurch bestimmt wird, dass:
- das Ilalbleitermodul (24) bei einer vorgegebenen Kühlung durch die Kühleinrichtung (20) im bestimmungsgemäßen Betrieb mit einer vorgegebenen elektrischen Beanspruchung (34) beaufschlagt wird, wobei die vorgegebene elektrische Beanspruchung vorgegebene Schaltmuster mit einer vorgegebenen Spannungs- und/oder Strombeanspruchung umfasst,
- ein thermischer Widerstand zwischen einem Halbleiterelement (28) des Halbleitermoduls (24) und der Kühleinrichtung (20) ermittelt wird,
- der ermittelte thermische Widerstand in einem zweiten Vergleich mit einem thermischen Referenzwiderstand verglichen wird, und
- Prognosedaten (44) für die noch verbleibende bestimmungsgemäße Nutzbarkeit des Halbleitermoduls bis zu einem Nutzbarkeitsende zumindest abhängig von dem zweiten Vergleich ermittelt werden,
wobei die elektrische Beanspruchung (34) des Halbleitermoduls (24) und die Kühlung während des bestimmungsgemäßen Betriebs erfasst werden und der Vergleich durchgeführt wird, sobald die vorgegebene elektrische Beanspruchung (34) bei der vorgegebenen Kühlung ermittelt wird, wobei die elektrische Maschine (12) gemäß einer Vektorsteuerung gesteuert und als vorgebbare elektrische Beanspruchung (34) ein ausschließlich feldbildender Strom bezüglich der elektrischen Maschine (12) eingestellt wird.

4. Verfahren nach einem der vorhergehenden Ansprüche, **dadurch gekennzeichnet , dass** die bezüglich der vorgegebenen Beanspruchung (34) bei der vorgegebenen Kühlung erfasste Temperatur (36) und/oder der ermittelte thermische Widerstand gespeichert wird.

5. Verfahren nach Anspruch 4, **dadurch gekennzeichnet, dass** durch die Speicherung die Alterung des Halbleitermoduls (24) derart dokumentiert wird, dass aufgrund von Alterungseffekten die Kühlungsfunktion verstärkt wird.

6. Verfahren nach einem der vorhergehenden Ansprüche, **dadurch gekennzeichnet, dass** die Prognosedaten (44) ermittelt werden, bevor ein Nutzbarkeitsende für eine bestimmungsgemäße Nutzbarkeit des Halbleitermoduls (24) erreicht ist.

7. Verfahren nach einem der vorhergehenden Ansprüche, **dadurch gekennzeichnet, dass** bei einer Differenz zwischen der erfassten Temperatur (36) und der Vergleichstemperatur und/oder einer Differenz zwischen dem ermittelten thermischen Widerstand und dem thermischen Referenzwiderstand, die größer als ein vorgegebener Referenzwert ist, das Nutzbarkeitsende angezeigt wird.

8. Verfahren nach einem der vorhergehenden Ansprüche, **dadurch gekennzeichnet , dass** abhängig von der Differenz zwischen der erfassten Temperatur (36) und der Vergleichstemperatur und/oder der Differenz zwischen dem ermittelten thermischen Widerstand und dem thermischen Referenzwiderstand ein Beanspruchungssignal zum Einstellen einer maximalen Beanspruchung des Halbleitermoduls (24) ausgegeben wird.

9. Verfahren nach einem der vorhergehenden Ansprüche **dadurch gekennzeichnet, dass** der feldbildende Strom außerhalb eines bestimmungsgemäßen Betriebs der elektrischen Maschine (12) eingestellt wird.

10. Steuereinheit (22) zum Steuern von wenigstens einem mit einer Kühleinrichtung (20) thermisch gekoppelten Halbleitermodul (24) wobei die Steuereinrichtung zur Durchführung eines Verfahrens nach einem der Ansprüche 1 bis 9 ausgebildet ist.

11. Energiewandler (14) zum Anschließen an eine elektrische Maschine (12), mit:
- wenigstens einem Halbleitermodul (24),
- wenigstens einer mit dem wenigstens einen Ilalbleitermodul (24) thermisch gekoppelten Kühleinrichtung (20),
- wenigstens einem mit dem wenigstens einen Halbleitermodul (24) elektrisch gekoppelten Energiespeicher (18),
- Anschlusskontakten (46) zum Anschließen der elektrischen Maschine (12),
- einem Zwischenkreisanschluss (48) zum Anschließen des Energiewandlers (14) an einen Gleichspannungszwischenkreis (16), und
- einer mit dem wenigstens einen Halbleitermodul (24) elektrisch gekoppelten Steuereinheit (22) zum Steuern des wenigstens einen Halbleitermoduls (24) in einem vorgebbaren Schaltbetrieb, um den Gleichspannungszwischenkreis (16) und die elektrische Maschine (12) elektrisch miteinander zu koppeln,
**dadurch gekennzeichnet, dass** die Steuereinheit (22) gemäß Anspruch 10 ausgebildet ist.

## Claims

1. Method for operating an energy converter (14) which can be connected to an electric machine (12) and which is configured to electrically couple the electric machine (12) to a d.c. link (16), for which purpose at least one semiconductor module (24) thermally coupled to a cooling device (20) interacts with at least one energy store (18) electrically coupled to the semiconductor module (24) and is operated for electrically coupling the d.c. link (16) to the electric machine (12) in a predefinable switching mode, wherein the remaining usability of the at least one semiconductor module (24) in normal use is determined, in that:
- a predefined electrical load (34) is applied to the semiconductor module (24) in normal operation while predefined cooling is effected by the cooling device (20), wherein the predefined electrical load comprises predefined switching patterns with a predefined voltage stress and/or current stress,
- a temperature (36) of a semiconductor element (28) of the semiconductor module (24) is sensed at least for the predefined electrical load (34) of the semiconductor module (24),
- the sensed temperature (36) is compared with a comparison temperature (40) in a first comparison, wherein the comparison temperature (40) is assigned to the predefined electrical load (34) while the predefined cooling is effected, and
- prediction data (44) for the remaining usability of the semiconductor module (24) in normal use up to an end of usability is determined at least as a function of the first comparison,
wherein the electrical load (34) of the semiconductor module (24) and the cooling during normal operation are sensed and the comparison is carried out as soon as the predefined electrical load (34) during the predefined cooling is determined, wherein the electric machine (12) is controlled in accordance with a vector controller and an exclusively field-forming current is set in respect of the electric machine (12) as a predefinable electrical load (34).

2. Method according to claim 1, **characterised in that** a thermal resistance between the semiconductor element (24) and the cooling device (20) is determined and the determined thermal resistance is compared with a thermal reference resistance in a second comparison, wherein the prediction data (44) is additionally determined as a function of the second comparison.

3. Method for operating an energy converter (14) which can be connected to an electric machine (12) and which is configured to electrically couple the electric machine (12) to a d.c. link (16), for which purpose at least one semiconductor module (24) thermally coupled to a cooling device (20) interacts with at least one energy store (18) electrically coupled to the semiconductor module (24) and is operated for electrically coupling the d.c. link (16) to the electric machine (12) in a predefinable switching mode, wherein the remaining usability of the at least one semiconductor module (24) in normal use is determined, in that:
- a predefined electrical load (34) is applied to the semiconductor module (24) while predefined cooling is effected by the cooling device (20) in normal operation, wherein the predefined electrical load comprises predefined switching patterns with a predefined voltage stress and/or current stress,
- a thermal resistance between a semiconductor element (28) of the semiconductor module (24) and the cooling device (20) is determined,
- the determined thermal resistance is compared with a thermal reference resistance in a second comparison, and
- prediction data (44) for the remaining usability of the semiconductor module in normal use is determined up to an end of usability at least as a function of the second comparison,
wherein the electrical load (34) of the semiconductor module (24) and the cooling during normal operation are sensed and the comparison is carried out as soon as the predefined electrical load (34) during the predefined cooling is determined, wherein the electric machine (12) is controlled in accordance with a vector controller and an exclusively field-forming current is set in respect of the electric machine (12) as a predefinable electrical load (34).

4. Method according to one of the preceding claims, **characterised in that** the temperature (36) sensed in respect of the predefined load (34) during the predefined cooling and/or the determined thermal resistance is stored.

5. Method according to claim 4, **characterised in that** thanks to the storage the aging of the semiconductor module (24) is documented such that the cooling function is increased on the basis of aging effects.

6. Method according to one of the preceding claims, **characterised in that** the prediction data (44) is determined before an end of usability for the usability of the semiconductor module (24) in normal use is reached.

7. Method according to one of the preceding claims, **characterised in that** in the event of a difference between the sensed temperature (36) and the comparison temperature and/or a difference between the determined thermal resistance and the thermal reference resistance which is greater than a predefined reference value, the end of usability is displayed.

8. Method according to one of the preceding claims, **characterised in that** as a function of the difference between the sensed temperature (36) and the comparison temperature and/or the difference between the determined thermal resistance and the thermal reference resistance a load signal to set a maximum load of the semiconductor module (24) is output.

9. Method according to one of the preceding claims, **characterised in that** the field-forming current is set externally to the normal operation of the electric machine (12) .

10. Control unit (22) for controlling at least one semiconductor module (24) thermally coupled to a cooling device (20), wherein the control unit (22) is embodied to carry out a method according to one of claims 1 to 9.

11. Energy converter (14) for connection to an electric machine (12), having:
- at least one semiconductor module (24),
- at least one cooling device (20) thermally coupled to the at least one semiconductor module (24),
- at least one energy store (18) electrically coupled to the at least one semiconductor module (24),
- connection contacts (46) for connection of the electric machine (12),
- a d.c. link terminal (48) for connecting the energy converter (14) to a d.c. link (16), and
- a control unit (22) electrically coupled to the at least one semiconductor module (24) for controlling the at least one semiconductor module (24) in a predefinable switching mode, in order to electrically couple the d.c. link (16) and the electric machine (12) to one another,
**characterised in that** the control unit (22) is embodied according to claim 10.

## Revendications

1. Procédé pour faire fonctionner un convertisseur (14) d'énergie, qui peut être raccordé à une machine (12) électrique et qui est conçu pour connecter électriquement la machine (12) électrique à un circuit intermédiaire (16) à tension continue, à cette fin au moins un module (24) à semiconducteur, couplé thermiquement à un dispositif (20) de refroidissement, coopère avec au moins un accumulateur (18) d'énergie connecté électriquement au module (24) à semiconducteur et, pour la connexion électrique du circuit intermédiaire (16) à tension continue à la machine (12) électrique, fonctionne dans un fonctionnement de commutation pouvant être donné à l'avance, dans lequel on détermine une possibilité d'utilisation restante conforme aux prescriptions du au moins un module (24) à semiconducteur en :
- soumettant le module (24) à semiconducteur, pour un refroidissement donné à l'avance par le dispositif (20) de refroidissement, dans le fonctionnement conforme aux prescriptions, à une sollicitation (34) électrique donnée à l'avance, dans lequel la sollicitation électrique donnée à l'avance comprend un modèle de commutation donné à l'avance, ayant une sollicitation de tension et/ou de courant donnée à l'avance,
- relevant une température (36) d'un élément (28) semiconducteur du module (24) à semiconducteur, au moins pendant la sollicitation (34) électrique donnée à l'avance du module (24) à semiconducteur,
- en comparant la température (36) relevée suivant une première comparaison à une température (40) de comparaison, la température (40) de comparaison étant associée à la sollicitation (34) électrique donnée à l'avance au refroidissement donné à l'avance, et
- en déterminant, au moins en fonction de la première comparaison, des données (44) de pronostic de la possibilité d'utilisation, conformément aux prescriptions, restante encore du module (24) à semiconducteur jusqu'à une fin de possibilité d'utilisation,
dans lequel on détecte la sollicitation (34) électrique du module (24) à semiconducteur et le refroidissement pendant le fonctionnement conformément aux prescriptions et on effectue la comparaison, dès que l'on détermine la sollicitation (34) électrique donnée à l'avance au refroidissement donné à l'avance, dans lequel la machine (12) électrique est commandée suivant une commande vectorielle et on établit, comme sollicitation (34) électrique pouvant être donnée à l'avance, un courant, en ce qui concerne la machine (12) électrique, donnant exclusivement un champ.

2. Procédé suivant la revendication 1, **caractérisé en ce que** l'on détermine une résistance thermique entre l'élément (24) à semiconducteur et le dispositif (20) de refroidissement, et on compare la résistance thermique déterminée dans une deuxième comparaison à une résistance thermique de référence, les données (44) de pronostic étant déterminées complémentairement en fonction de la deuxième comparaison.

3. Procédé pour faire fonctionner un convertisseur (14) d'énergie, qui peut être raccordé à une machine (12) électrique et qui est conçu pour connecter électriquement la machine (12) électrique à un circuit intermédiaire (16) à tension continue, à cette fin, au moins un module (24) à semiconducteur, couplé thermiquement à un dispositif (20) de refroidissement, coopère avec au moins un accumulateur (18) d'énergie connecté électriquement au module (24) à semiconducteur et, pour la connexion électrique du circuit intermédiaire (16) à tension continue à la machine (12) électrique, fonctionne dans un fonctionnement de commutation pouvant être donné à l'avance, dans lequel on détermine une possibilité d'utilisation restante conforme aux prescriptions du au moins un module (24) à semiconducteur :
- en soumettant le module (24) à semiconducteur, pour un refroidissement donné à l'avance par le dispositif (20) de refroidissement dans le fonctionnement conforme aux prescriptions, à une sollicitation (34) électrique donnée à l'avance, dans lequel la sollicitation électrique donnée à l'avance comprend un modèle de commutation donnée à l'avance, ayant une sollicitation de tension et/ou de courant donné à l'avance,
- en déterminant une résistance thermique entre l'élément (28) semiconducteur du module (24) à semiconducteur et le dispositif (20) de refroidissement,
- en comparant la résistance thermique déterminée dans une deuxième comparaison à une résistance thermique de référence, et
- en déterminant, au moins en fonction de la deuxième comparaison, des données (44) de pronostic de la possibilité d'utilisation conformément aux prescriptions restant encore du module à semiconducteur jusqu'à une fin de possibilité d'utilisation,
dans lequel on détecte la sollicitation (34) électrique du module (24) à semiconducteur et le refroidissement pendant le fonctionnement conformément aux prescriptions et on effectue la comparaison, dès que l'on détermine la sollicitation (34) électrique donnée à l'avance au refroidissement donné à l'avance, dans lequel la machine (12) électrique est commandée suivant une commande vectorielle et on établit, comme sollicitation (34) électrique pouvant être donnée à l'avance, un courant, en ce qui concerne la machine (12) électrique, donnant exclusivement un champ.

4. Procédé suivant l'une des revendications précédentes, **caractérisé en ce que** l'on met en mémoire la température (36) relevée concernant la sollicitation (34) donnée à l'avance au refroidissement donné à l'avance et/ou la résistance thermique déterminée.

5. Procédé suivant la revendication 4, **caractérisé en ce que**, par la mise en mémoire, on documente le vieillissement du module (24) à semiconducteur, de manière à renforcer la fonction de refroidissement en raison d'effets de vieillissement.

6. Procédé suivant l'une des revendications précédentes, **caractérisé en ce que** l'on détermine les données (44) de pronostic avant d'atteindre une fin de possibilité d'utilisation conforme aux prescriptions du module (24) à semiconducteur.

7. Procédé suivant l'une des revendications précédentes, **caractérisé en ce que** l'on indique une fin de possibilité d'utilisation, si une différence entre la température (36) relevée et la température de comparaison et/ou une différence entre la résistance thermique déterminée et la résistance thermique de référence est plus grande qu'une valeur de référence donnée à l'avance.

8. Procédé suivant l'une des revendications précédentes, **caractérisé en ce que**, en fonction de la différence entre la température (36) relevée et la température de comparaison et/ou de la différence entre la résistance thermique déterminée et la résistance thermique de référence, on émet un signal de sollicitation pour régler une sollicitation maximum d'un module (24) à semiconducteur.

9. Procédé suivant l'une des revendications précédentes, **caractérisé en ce que** l'on règle le courant formant un champ à l'extérieur d'un fonctionnement conforme aux prescriptions de la machine (12) électrique.

10. Unité (22) de commande pour la commande d'au moins un module (24) à semiconducteur couplé thermiquement à un dispositif (20) de refroidissement, le dispositif de commande étant constitué pour effectuer un procédé suivant l'une des revendications 1 à 9.

11. Convertisseur (14) d'énergie à raccorder à une machine (12) électrique, comprenant :
- au moins un module (24) à semiconducteur,
- au moins un dispositif (20) de refroidissement couplé thermiquement au au moins un module (24) à semiconducteur,
- au moins un accumulateur (18) d'énergie connecté électriquement au au moins un module (24) à semiconducteur,
- des contacts (46) de connexion pour la connexion de la machine (12) électrique,
- une borne (48) de circuit intermédiaire pour la connexion du convertisseur (14) d'énergie à un circuit intermédiaire (16) à tension continue, et
- une unité (22) de commande, connectée électriquement au au moins un module (24) à semiconducteur, pour la commande du au moins un module (24) à semiconducteur dans un fonctionnement de commutation pouvant être donné à l'avance, afin de connecter électriquement entre eux le circuit intermédiaire (16) à tension continue et la machine (12) électrique,
**caractérisé en ce que** l'unité (22) de commande est constituée suivant la revendication 10.
